(19) **Europäisches Patentamt European Patent Office Office européen des brevets**

(11) **EP 4 194 791 B1**

(12) **EUROPEAN PATENT SPECIFICATION**

(45) Date of publication and mention
of the grant of the patent:
**05.11.2025 Bulletin 2025/45**

(21) Application number: **21213459.7**

(22) Date of filing: **09.12.2021**

(51) International Patent Classification (IPC):
**F28D 20/02** (2006.01)

(52) Cooperative Patent Classification (CPC):
**F28D 20/021; F28D 20/028;** Y02E 60/14

(54) **DETERMINING A STATE-OF-CHARGE OF A PHASE-CHANGE-MATERIAL-BASED THERMAL ENERGY STORAGE DEVICE**

BESTIMMUNG DES LADEZUSTANDS EINER VORRICHTUNG ZUR SPEICHERUNG VON THERMISCHER ENERGIE BASIEREND AUF PHASENWECHSELMATERIALIEN

DÉTERMINATION D'UN ÉTAT DE CHARGE D'UN DISPOSITIF DE STOCKAGE D'ÉNERGIE THERMIQUE À BASE DE MATÉRIAU À CHANGEMENT DE PHASE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**14.06.2023 Bulletin 2023/24**

(73) Proprietors:
• **Mitsubishi Electric R&D Centre Europe B.V.**
**Livingston EH54 5DJ (GB)**
Designated Contracting States:
**GB**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI FR GR HR HU IE IS IT LI LT LU LV MC MK MT NL NO PL PT RO RS SE SI SK SM TR**

(72) Inventors:
• **OLKIS, Christopher**
**Livingston EH54 5 DJ (GB)**
• **KAWALEY, Georgeanna**
**Livingston EH54 5DJ (GB)**
• **FREEMAN, James**
**Livingston EH54 5DJ (GB)**

(74) Representative: **Pfenning, Meinig & Partner mbB**
**Patent- und Rechtsanwälte**
**Theresienhöhe 11a**
**80339 München (DE)**

(56) References cited:
EP-A2- 2 482 021          WO-A1-2014/191778
WO-A2-2012/124932          US-A1- 2014 102 662
US-A1- 2014 158 340

**Description**

Field of the invention

The invention relates to a method for determining a state-of-charge, SOC, of a phase-change-material-based thermal energy storage device with a storage module that comprises a phase change material for storing thermal energy, with the method step of measuring at least one surface temperature at the storage module of the phase-change-material-based thermal energy storage device, PCM-TES which can be combined with an outlet temperature based SOC.

Background

Latent heat thermal energy storage devices with phase change materials, PCMs, are getting more and more popular. They exploit the latent heat of fusion at a specific melting temperature. The latent heat of fusion is substantially larger than the sensible heat of a fluid over a storage temperature difference of 10 Kelvin. Thus, latent heat thermal energy storage devices offer an advanced alternative to sensible heat storage devices such as hot water storage tanks.
Generally speaking, the state-of-charge, SOC, of a thermal energy storage device may refer to a level of energy stored in said thermal energy store relative to a given upper and a given lower energy limit. The upper limit can be determined by a calibration of the thermal energy storage, e.g. enthalpy-based calibration. The state-of-charge thus can indicate a remaining energy storage level of the storage device. More generally speaking, the state-of-charge relates to the energy available in the thermal energy storage device.
The state-of-charge of a sensible heat energy storage system can be determined by the temperature and the specific heat capacity of the storage fluid used. By contrast, determining the state-of-charge of a latent heat storage is more challenging, as the latent heat of fusion is released at a single melting temperature. Thus, more sophisticated approaches are required to obtain the SOC of a PCM-TES, and a range of different methods have been described.
EP 2 482 021 A2 describes how a state-of-charge of a latent heat TES can be determined by measuring the gas expansion inside a sealed PCM tank. The volume of the PCM changes with the phase transition from solid to liquid. The PCM volume change is thus reflected in a pressure change, which can be determined by a pressure sensor, hence providing information on the state-of-charge. The proposed method is thus volume-based.
AU 2018 202 778 B2 discloses a PCM-TES, where the SOC is determined from power sensors through an enthalpy analysis. The power sensors are comprised of a combination of flow sensors, temperature sensors at the inlet/outlet, and a computation engine to derive thermal power. The proposed method is thus enthalpy-based.
US 2014/102 662 A1 describes how the state-of-charge of a thermal energy battery/store can be obtained from a single temperature sensor placed at the bottom of the fluid container of the battery. The proposed method is thus temperature-based.
EP 3 336 473 A1 describes a solution where the SOC is determined by at least two temperature sensors that are placed on a PCM tank surface. The PCM is charged with a heat transfer fluid, HTF. The temperature sensors may be placed between the PCM tank wall and an insulation of the tank wall on the outside. A computer converts the measured temperatures into a temperature field, where the temperature field corresponds to an SOC field. In order to achieve this, each temperature sensor provides temperature as well as the temperature time derivative as an input to a temperature field model, which is based on a spatial model of the PCM container at hand. So, the temperature field represents an SOC distribution, where the use of more temperature sensors increases the resolution. Also, this method is thus temperature-based.
WO 2018/122392 A1 discloses how a single temperature sensor can be used to enable a model-based state-of-charge prediction of a latent heat thermal energy storage device. The method uses previous, historical data of the sensor and applies a model, with a Monte Carlo method being applied to estimate the model parameters. The most appropriate model is then selected by the method to predict the SOC. The proposed method is computationally expensive, but temperature-based as well.
US 2014/158340 A1 describes cooling an energy storage module using passive and active cooling techniques.
US 2014/158340 A1 discloses a method as defined in the preamble of claim 1 and a storage device as defined in the preamble of claim 12.

Summary of the invention

It hence can be considered an objective technical problem to be solved by the invention at hand to determine a state-of-charge, SOC, of a phase-change-material-based thermal energy storage device, PCM-TES, in a simple and reliable way.
Said problem is solved by the independent claims. Advantageous embodiments are apparent from the dependent claims, the description, and the figures.

One aspect relates to a method for determining a state-of-charge, SOC, of a phase-change-material-based thermal energy storage device, PCM-TES, with a storage module that comprises a phase change material for storing thermal energy. The storage module may, depending on the respective advantageous embodiment, be or comprise a tank cell with an inlet and outlet for a heat transfer fluid, as well as, a capsule for encapsulated PCM floating in such a tank cell. Correspondingly, depending on the respective embodiment, the storage module may also be referred to as containment module, PCM-capsule, as container, or as tank cell.

The method comprises a method step of measuring at least one surface temperature, that is, one or more surface temperatures, at the storage module of the PCM-TES as a first temperature. This can be done by a corresponding first temperature sensor unit. The at least one surface temperature may be measured at a surface of the storage module, in particular at a surface of the tank cell or surface of a PCM capsule. To this end, the temperature sensor may be arranged accordingly. Consequently, the at least one surface temperature may be a temperature of a storage module wall, for instance of a tank wall and/or of a capsule wall.

Another method step is the step of determining an operating condition of the PCM-TES. This can be done by a determination unit such as a controller with a microchip. Therein, if the operating condition is determined to be an active condition where the heat transfer fluid is flowing through the outlet of a tank, in particular of the storage module, of the PCM-TES, additional steps are executed. In particular, the active condition may refer to a condition where the PCM-TES is charged or discharged.

One additional step is the step of measuring a liquid temperature at the outlet of the PCM-TES as a second temperature. This can be done by a corresponding second temperature sensor unit. The liquid temperature may be a temperature of the heat transfer fluid flowing through the outlet. The outlet may be part of a heat exchanger. Another additional step is the step of calculating at least one first SOC-value, $SOC_{surface}$, with, i.e. using, a first chosen or preset/given function of the first temperature. So, the first SOC-value is calculated or derived from said first chosen function, which maps values of the first temperature on the respective SOC-value. Another additional step is the step of calculating a second SOC-value, $SOC_{outlet}$, with a second chosen function of the second temperature. Correspondingly, the second chosen function maps value of the second temperature on the second SOC-value. The second chosen function may be a step function. A subsequent additional step is the step of determining the SOC of the PCM-TES with a third chosen function of the at least one calculated first SOC-value and of the calculated second SOC-value. Thus, the third chosen function maps first and second SOC-values on the SOC of the PCM-TES to be determined. The calculating and determining steps can be done by the determination unit.

This gives the advantage of enabling a non-invasive, accurate, inexpensive, temperature-based method for analysing the state-of-charge for latent thermal energy storage devices, that is, PCM-TESs. The proposed method combines two different, temperature-based methods, a surface temperature-based method and an outlet temperature-based method. The surface temperature sensor responds even if the PCM-TES is in an idle condition, that is, even if the PCM-TES is not actively being charged or discharged, a condition where the limitations of heat transfer from the heat transfer fluid/PCM to the respective temperature sensor used for measuring the surface temperature delays the temperature response. The outlet temperature method enables instant, fast SOC assessment, but requires a heat transfer fluid, HTF, to actively flow through the PCM-TES. Thus, a PCM-TES in an idle condition cannot be analysed by the outlet temperature method, which can be circumvented using HTF loop coupling the outlet with an inlet of the PCM-TES, with the HTF being pumped through the loop even when no discharging or charging takes place. Consequently, in order to calculate $SOC_{outlet}$ the second temperature may be measured in active condition. Alternatively. The second temperature may be measured in a pseudo-active condition, where said HTF loop is coupling the outlet with an inlet of the PCM-TES, with the HTF being pumped through the loop even when no discharging or charging takes place. The fast response of the outlet temperature method enables prediction even at very high charging and discharging rates of the PCM-TES, where the response time of the surface temperature method would be to slow.

So, the surface temperature response to the actual SOC can be delayed due to heat transfer limitations in the surface temperature method, while the outlet temperature method tends to overestimate the SOC. To enhance the accuracy, the two methods can be combined appropriately, for instance, by calculating the mean value of the two temperature-based methods. The accuracy can be further improved by switching from the combined method to only applying the surface temperature method when the PCM-TES is idling.

Correspondingly, in the proposed solution, the two methods are linked together, depending on the condition of the PCM-TES. If the PCM-TES is active and heat transfer fluid is flowing through the tank cell, i.e. charging or discharging takes place, a combination of surface and outlet temperature method is applied. This combination is not necessary in an idle or passive condition of the PCM-TES where, accordingly, at least in a longer-lasting idle condition, a simpler algorithm can be used. The proposed method relies on temperature sensors only, and requires only minimal instrumentation, that is, one or more first surface temperature sensors and one second outlet temperature sensor. Also, a much simpler mathematical model can be employed as compared with the known state-of-the-art, in particular, no ordinary or partial differential equations have to be solved for determining the SOC by the determination unit. Also, no temperature field is calculated, and the minimal number of sensors, only two temperature sensors, are required for the method to work. The combination of the different methods allows a fast and precise analysis of the current SOC.

Furthermore, as determining the state-of-charge is important for any control strategy of thermal energy storage devices in combination with heat sources such as boilers, heat pumps, or the like, there is a high demand for methods and systems that can also be applied to already installed systems, existing systems, which needs to be retrofitted. As the proposed method relies only on non-invasive sensors which are easy to apply, and existing systems can be enhanced with the proposed method as the tank cell or containment cell of the PCM-TES can remain sealed and the risk of leakage to the environment is reduced. The proposed method allows to monitor the SOC frequently, and can also be operated independently of the heat source status. It does not require recalibration and is based on simple mathematical correlations.

In one advantageous embodiment, the operating condition to be determined is chosen from a given set of discrete operating conditions, preferably comprising the active condition and the idle or passive condition where the heat transfer fluid is not flowing through the outlet of the tank of the PCM-TES, preferably not through any outlet. In particular, the given set of discrete operating conditions may comprise only the active condition and the idle condition. This gives the advantage of a particular simple implementation.

In another advantageous embodiment, the method comprises, if the operating condition is determined to be the idle condition, a method step of determining the SOC of the PCM-TES with a fourth chosen function of the first temperature, where the fourth chosen function is different from the third chosen function. So, the SOC of the PCM-TES is calculated differently in active and idle condition. In particular, said fourth chosen function of the first temperature is identical to the first chosen function of the method step of calculating at least one first SOC-value, which is described above, and/or a chosen function converting, preferably continuously converting, the third chosen function into the first chosen function over time after the idle condition has been determined. So, the function determining the SOC of the PCM-TES may be a piecewise defined function, with the third function being used for determination before a starting time of the idle condition, and said fourth given function of this paragraph being used for determination during the idle condition, i.e. during idle time. The fourth function preferably connects to the third function continuously at idle time $ti_{idle}=0$, i.e. the start of the idle connection. With increasing duration of the idle condition, during a transition period $0< t_{idle}<t_{idle,trans}$, which may be adjusted e.g. to 120 minutes, the fourth function in this case approximates the first function, preferably continuously connecting to the first function for $t_{idle}= t_{idle,trans}$ or at least $t_{idle}\rightarrow\infty$. For idle times after the transition time, $t_{idle}> t_{idle,trans}$, the fourth given function may thus be the first given function. For the transition period $0< t_{idle}<t_{idle,trans}$ transition, the fourth function may comprise a linear, sigmoidal, hyperbolic function or any combination thereof, as described also below. So, the fourth function may be referred to as transition function, the first function as surface function, the second function as outlet function, and the third function as mean function.

This gives the advantage that the two different, temperature-based methods, the surface temperature method and outlet temperature method, can belinked together in two different ways depending on the status or operating condition of the PCM-TES. So, if the PCM-TES is active and heat transfer fluid is flowing through the cell, a combination of surface and outlet temperature method is applied. If the PCM-TES is idling and no heat transfer fluid flow is present, it is, at least after a while (when the system is stabilized, e.g. after 120 minutes), switched to applying the surface temperature method alone in order to take heat losses into account. Thus, the overall method accurately predicts the state-of-charge at all PCM-TES operating conditions, that is, at high heat flow rates during charging and discharging the PCM-TES and even when the system is idling.

In another advantageous embodiment, in the measuring step of measuring at least one surface temperature as a first temperature, several surface temperatures are measured as respective several first temperatures, where the respective surface temperatures correspond to different zones of the tank cell, in particular of the storage module, of the PCM-TES. Furthermore, in the method step of calculating at least one first SOC-value with a first chosen function of the first temperature, several first SOC-values are calculated with said first given function from the measured several first temperatures. Furthermore, in the method step of determining the SOC of the PCM-TES with the third function, the SOC of the PCM-TES is determined by a sum of respective third chosen functions, which are the third chosen functions of the respective first calculated SOC-value and of the calculated second SOC-value. This gives the advantage of an increased accuracy, where the SOC is determined for each individual zone independently, and then added up to arrive at the overall SOC of the PCM-TES as a whole. It is also possible to measure several first temperatures, and then derive an improved first temperature for instance by averaging the individual first temperatures. If all first temperatures are merged into one single improved first temperature, the tank cell is treated as one single zone. If all first temperatures are used for respective individual SOC-values, the tank cell is treated as having a corresponding number of individual zones. In both cases accuracy is improved in different ways. The approaches can also be mixed.

This is very similar to a setting where the proposed method is applied individually to a number of PCM-TES tank cells that are charged and discharged one by one in a serial configuration where the outlet of one tank cell is fluidically coupled with the inlet of the subsequent tank cell. Therein, for improved clarity with simplified computation, the SOC determined for each PCM-TES tank cell individually can be represented by an individual Boolean charging bar for an SOC indicator, indicating a total SOC of the complete system. So, if the PCM-TES comprises several tank cells, suitable flow configuration between them can be applied to improve the accuracy of the SOC prediction.

In another advantageous embodiment, the SOC determined with the third chosen function of the method step of determining the SOC of the PCM-TES, i.e. the third chosen function, is proportional to a weighted average of the first SOC-value and the second SOC-value. In particular, the third chosen function may be given by $SOC_{combined} = Z_1 * SOC_{surface} + Z_2 * SOC_{outlet}$, with $z_1$ and $z_2$ being constant values. This has been proven an efficient way to enable a more precise determination of the SOC of the PCM-TES.

In advantageous embodiment, the fourth given function is given by $SOC_{total} = y_1(t_{idle}) * SOC_{surface} + y_2(t_{idle}) * SOC_{combined}$, where $y_1(t_{idle})$ and $y_2(t_{idle})$ vary with idling time $t_{idle}$ of the PCM-TES (1) and $y_1(t_{idle}) + y_2(t_{idle}) = $ constant, in particular $y_1(t_{idle}) + y_2(t_{idle}) = 1$. The idling time $t_{idle}$ is a time measured from the time where the idle condition is determined. This realizes a smooth transition of the SOC as determined in the different conditions and reflects the delay in the temperature response of the surface temperature method which is due to heat transfer limitations. Thus, $y_1(t_{idle})$ may be a monotonically increasing function and $y_2(t_{idle})$ a monotonically decreasing function. In particular, $y_1(t_{idle})$ and/or $y2(t_{idle})$ may be or comprise a linear, sigmoidal, hyperbolic function or any combination thereof. For instance, $y_1(t_{idle}=0) = 0$ and $y_2(t_{idle}=0) = 1$, and preferably $y_1(t_{idle} \to \infty) = 1$ and $y_2(t_{idle} \to \infty) = 0$. This result in a particularly smooth transition of the SOC prediction in idle condition and an active condition. Alternatively, this can be achieved in a mathematically equivalent manner using $y_1(t_{active}=0) = 1$ and $y_2(t_{active}=0) = 0$, and preferably with $y_1(t_{active} \to \infty) = 0$ and $y_2(t_{active} \to \infty) = 1$, where active time $t_{active}$ of the PCM-TES (1) replaces idling time $t_{idle}$ in the equations above and is a time measured from the time where the active condition is determined.

In a particularly advantageous embodiment, the first given function is an empiric function mapping the first temperature to an enthalpy-based SOC-value $SOC_{enthalpy}$. $SOC_{enthalpy}$ is later used to calibrate the surface-temperature-based $SOC_{surface}$ method, i.e. to calibrate the $SOC_{surface}$ function, which is a function of the surface temperature. Once $SOC_{surface}$ is fitted to $SOC_{enthalpy}$, $SOC_{enthalpy}$ is not needed for anything else. $SOC_{enthalpy}$ is preferably determined based on the equation:

$$SOC_{enthalpy} = {}_0\int^t \dot{m}_{HTF} * c_{p, HTF} * \left( T_{HTF, in} - T_{HTF} \right) / Q_{total},$$

wherein $\dot{m}_{HTF}$ is a flow rate of the heat transfer fluid, HTF, $c_{p, HTF}$ is a specific heat capacity of the heat transfer fluid, $T_{HTF, in}$ is a heat transfer fluid inlet temperature at the inlet of the PCM-TES, $T_{HTF}$ is a heat transfer fluid outlet temperature at the outlet of the PCM-TES (which corresponds to the second temperature), and $Q_{total}$ is a total heat storage capacity at a selected maximum temperature of operation of the PCM-TES relative to an reference value. The reference value may be a heat energy content of the heat storage capacity at the mains water inlet temperature. So, the first temperature may be calibrated against $SOC_{enthalpy}$ to obtain a $SOC_{surface}$ as first function.

The heat storage capacity can be defined by the sum of the sensible heat stored in the liquid and solid PCM as well as the heat of fusion and the heat stored in the additional components of the PCM-TES such as heat exchangers and vessel:

$$Q_{total} = m_{PCM} * c_{p, s, PCM} * \left( T_{PCM, melt} - T_{TES, min} \right) + + m_{PCM} * c_{p, l, PCM} \left( T_{TES, max} - T_{PCM, melt} \right) + + m_{PCM} * \Delta h_{fus, PCM} + m_{add} * c_{p, add} * \left( T_{TES, max} - T_{TES, min} \right),$$

Wherein $m_{PCM}$ is the mass of the PCM, $c_{p, s, PCM}$ and $c_{p, l, PCM}$ are the specific heat capacity of solid and liquid PCM, respectively, $\Delta h_{fus, PCM}$ is the latent heat of the fusion, $c_{p, add}$ is the cumulative specific heat capacity of the additional PCM-TES components, and $m_{add}$ is the mass of the additional PCM-TES components. $T_{PCM, melt}$ is the melting temperature of the PCM, $T_{TES, min}$ and $T_{TES, max}$ are lower and upper temperature limit for PCM-TES during intended use. So, for the enthalpy-based SOC calculation, suitable upper and lower reference temperatures $T_{TES, max}$ and $T_{TES, min}$ need to be chosen such that the lower temperature $T_{TES, min}$ is likely to be reached by the discharged PCM-TES and the maximum temperature $T_{TES, max}$ corresponds to a maximum temperature of the heat source.

In order to approximate the SOC of a PCM-TES from surface temperature measurements, surface temperature measurements over a wide range of operating conditions have to be fitted to the SOC determined from the second precisely calibrated $SOC_{enthalpy}$ method described above. Exemplary fitting functions may include, but are not limited to sigmoidal functions, polynomials, or piecewise defined functions. The fitting method includes an enthalpy-based method to determine the SOC using both flow meters and temperature sensors at the inlet and the outlet of the tank cell for measuring an energy balance and finally calculate the enthalpy-based SOC. In addition, at least one temperatures sensor for measuring the surface temperature is required to be able to correlate surface temperature with the SOC calculated based on enthalpy. The surface temperatures measured during the calibration are linked to the enthalpy-based SOC by their corresponding times. Thus, surface temperatures and enthalpy-based SOC can be correlated and result is the first chosen function.

For temperatures significantly below or above the PCM phase transition temperature, the SOC increase is attributed to sensible heat. The most significant SOC change takes place during phase transition, caused by the latent heat of fusion. Using surface temperatures, the phase transition area is wide and not strictly limited to the specific melting temperature of the PCM. Namely, heat transfer limitations delay the change of the surface temperature response to the SOC and widen the phase transition area. In order to obtain the first chosen function, the enthalpy-based SOC is fitted to the surface temperature with a suitable fit function. If multiple temperature sensors are used, the mean value of the sensors can be used to simplify calculations, but functions using each sensor or combinations of sensors as a variable can be applied for higher accuracy as well. Therein, the surface measurements may be split into zones, and respective functions then fit to each zone as described above.

The first chosen function can be designed to be independent of the flow conditions and/or the PCM-TES operating conditions, but it can also be specifically fitted to each operating condition, or even to respective SOC conditions, that is, different idle conditions or different active conditions. Consequently, the precision of the method can be increased, and since the first given function only needs to be determined once with a single fitting process, the determination unit of the respective phase-change-material-based thermal energy storage device needs only to perform a simple calculation and requires only said two temperatures as input.

In another advantageous embodiment, the second given function is a step function mapping the second temperature to the SOC-value. The outlet temperature method for determining the SOC is straightforward to implement and requires only one temperature sensor at the outlet of the tank cell in order to measure the liquid temperature. It does not require any preliminary experiments or empiric fitting of functions, because the SOC is defined by the melting temperature of the PCM. Therefore, said step function can be applied as second function to correlate the liquid temperature to the SOC. In the simplest adaptation, the SOC = 0 for heat transfer fluid temperatures lower than or equal to the melting temperature of the PCM, and SOC = 1 for heat transfer fluid temperatures in the liquid state that are higher than the melting temperature of the PCM. Step functions with different intervals and step sizes can also be applied, for instance with a SOC of 0.5 in a given surrounding of the melting temperature of the PCM.

Another aspect not falling under the scope of protection relates to a computer program product comprising instructions which, when the program is executed by a computer, cause the computer to carry out the method of any of the described embodiments.

An additional aspect relates to a phase-change-material-based thermal energy storage device with a storage module that comprises a phase change material for storing thermal energy, at least one first temperature sensor unit for measuring a respective surface temperature at the storage module as a first temperature, a second temperature sensor unit for measuring a heat transfer fluid temperature at an outlet of the PCM-TES as a second temperature, and a determination unit for determining an operating condition of the PCM-TES. The determination unit is also configured for, when the operating condition is determined to be an active condition where a heat transfer fluid is flowing through the outlet of the PCM-TES, determining a state-of-charge of the PCM-TES with a third chosen function of at least one calculated first SOC-value, in which first SOC-value is calculated with a first chosen function of the first temperature, and of a calculated second SOC-value, in which second SOC-value is calculated with a second chosen function of the second temperature.

Further aspects not falling under the scope of protection relate to a retrofit kit for a PCM-TES, retrofit kit including said determination unit, in particular also the at least one first temperature sensor and/or the second temperature sensor unit, and/or to a determination unit for the described PCM-TES.

Advantages and advantageous embodiments of the PCM-TES, the retrofit kit, and the determination unit, correspond to advantages and advantageous embodiments of the described method.

The features and combinations of features described above, including the general part of the description, as well as the features and combinations of features disclosed in the figure description or the figures alone may not only be used alone or in the described combination, but also with other features or without some of the disclosed features without departing the scope of the present disclosure. Consequently, embodiments that are not explicitly shown and described by the figures but that can be generated by separately combining the individual features disclosed in the figures are also part of the present disclosure. Therefore, embodiments and combinations of features that do not comprise all features of an originally formulated independent claim are to be regarded as disclosed. Furthermore, embodiments and combinations of features that differ from or extend beyond the combinations of features described by the dependencies of the claims are to be regarded as disclosed.

Detailed description

Exemplary embodiments are further described in the following by means of schematic drawings. Therein,

Fig. 1 shows a first exemplary embodiment of a phase-change-material-based thermal energy storage device;

Fig.2 shows another exemplary embodiment of a phase-change-material-based thermal energy storage device;

Fig.3 shows an exemplary serial configuration of tanks cells in a phase-change-material-based thermal energy storage device;

Fig. 4    shows an exemplary embodiment of a tank cell of a PCM-TES with an exemplary embodiment of an encapsulated phase change material; and

Fig.5    shows another exemplary embodiment of a tank cell of a PCM-TES with an exemplary embodiment of an encapsulated phase change material.

In the different figures, identical or functionally identical features have the same reference signs.

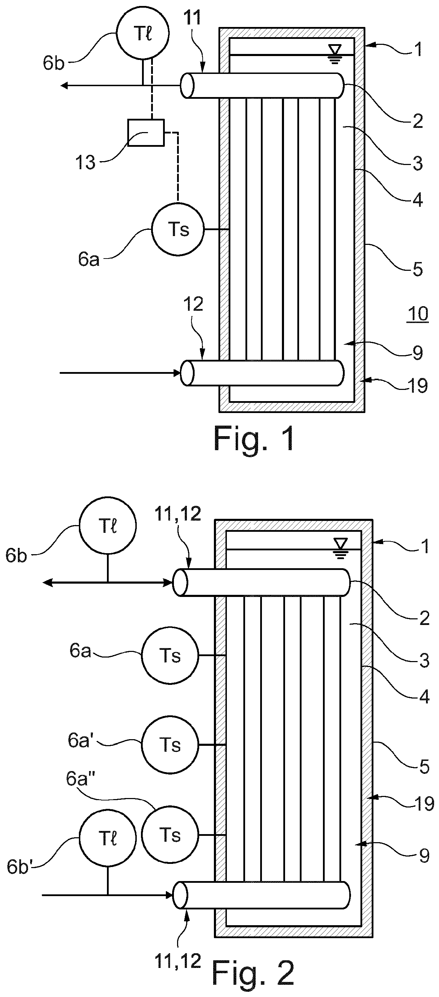

Fig. 1 shows an exemplary embodiment of a phase-change-material-based thermal energy storage device 1, PCM-TES 1. A storage module 9 that comprises a phase change material 3, PCM 3, for storing thermal energy, with at least one, here, exactly one first temperature sensor unit 6a for measuring a respective surface temperature Ts of a wall 4 of the storage module 9. An insulation 5 insulates the storage module 9, which is a tank cell 19 in the present example, from the ambient 10. In the storage module 9, the tank cell 19 of the PCM-TES 1, a heat exchanger 2 is placed. Said heat exchanger has an outlet 11, as well as an inlet 12, which thus are outlet and inlet of the PCM-TES 1. At the outlet 11 of the PCM-TES 1, a second temperature sensor unit 6b is placed for measuring a liquid temperature Tl, that is, a temperature of a heat transfer fluid flowing through the heat exchanger, and thus outlet 11, as a second temperature. Both temperature sensor units 6a, 6b are connected to a determination unit 13. The determination unit 13 is configured for determining an operating condition of the PCM-TES 1, and, if the operating condition is determined to be an active condition where a heat transfer fluid is flowing through the outlet 11 of the PCM-TES 1, also for determining a state-of-charge, SOC of the PCM-TES 1 with a third given function of at least one calculated first SOC-value, which is calculated with the first given function of the first temperature, and of a calculated second SOC-value, which is calculated with a second given function of the second temperature.

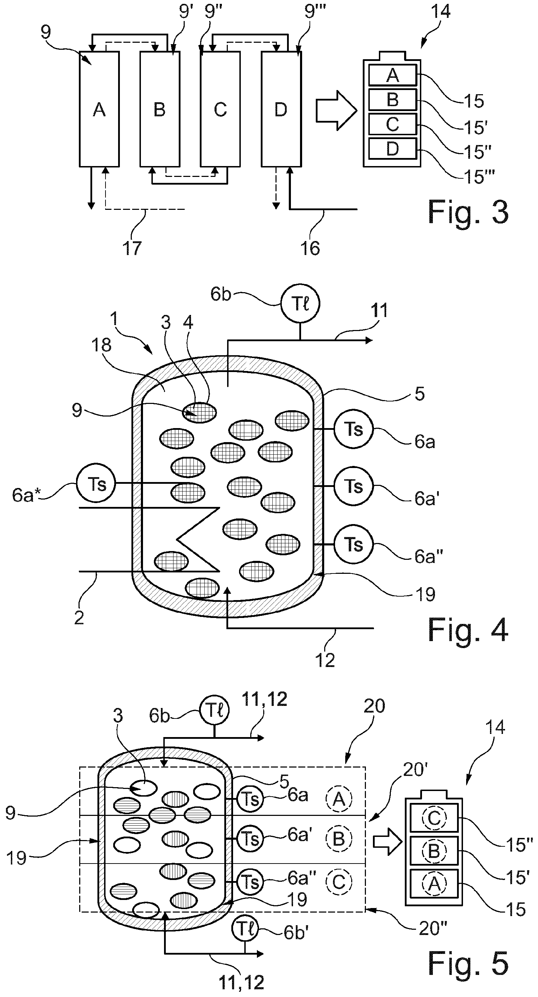

Fig. 2 shows another exemplary embodiment of a phase-change-material-based thermal energy storage device 1. Therein, several, in the present example three first temperature sensor units 6a, 6a', 6a" are installed for measuring respective surface temperatures Ts of the wall 4 as respective first temperatures. The use of several first temperature sensor units 6a, 6a', 6a" installed at different positions enables the measuring of respective surface temperatures Ts in different zones 20, 20', 20" (Fig. 5) corresponding to these positions, thus determining the SOC individually for the different zones. Thus, the accuracy of determining the SOC can be improved.

Furthermore, the second temperature sensor units 6b, 6b' are installed in the shown example. The presence of two second temperature sensor units 6b, 6b' at respective outlets 11 and inlets 12 enables the determination unit to determine the state-of-charge in both a heating and a cooling mode, as in heating versus cooling mode, the function of the respective outlet/inlet that is inversed. The determination unit 13 is omitted in the drawing for the sake of clarity.

Fig. 3 shows a part of a PCM-TES 1 with several, here four, tank cells labelled A, B, C, D as storage modules 9, 9', 9", 9''' that are connected serially. Two arrows 16, 17 display the directions through said different storage modules 9, 9', 9", 9'''. Arrow 16 indicates an inlet flow direction when the PCM-TES 1 is charged, and arrow 17 indicates an inlet flow direction when the PCM-TES 1 is discharged. Correspondingly, a display 14 for displaying the SOC of the PCM-TES 1 may feature respective Boolean charging bars 15, 15' 15", 15''' which correspond to the individual tank cells as individual storage modules 9, 9', 9", 9'''. For the sake of convenience, the tank cells and corresponding Boolean charging bars 15, 15' 15", 15''' are indicated by corresponding letters A, B, C, D, respectively. So, the shown serial configuration of the tank cells contributes to a precise and clear information on the SOC, which can be realized using even a simple step function as second chosen function.

Fig. 4 shows another exemplary embodiment of the PCM-TES 1, where in addition to first temperature sensor units 6a, 6a', 6a" a further first temperature sensor unit 6a* is used. Said further first temperature sensor unit 6a* improves the accuracy of the system, as it measures a respective surface temperature of an encapsulated PCM 3 in storage module 9. Namely, in the present example, the PCM 3 is floating as encapsulated PCM 3 in another liquid 18 such as water. The different first temperatures measured by the respective first temperature sensor unit 6a, 6a', 6a", 6a* can be used for an improved accuracy of the system, for instance, by taking an average of said first temperatures as the effective first temperature used for determining the SOC of the PCM-TES one.

Fig. 5 shows another possibility of advantageously using the different first temperature sensor units 6a, 6a', 6a". As the first temperature sensor units 6a, 6a', 6a" are arranged on different portions of the wall 4 of the tank cell 19 of the PCM-TES. So, every first temperature sensor unit 6a, 6a', 6a" corresponds to a specific zone 20, 20', 20" for each of which the SOC can be calculated independently of the SOC of the other zones. The overall SOC of the PCM-TES 1 can then be calculated as an average of the individual SOCs of the different zones 20, 20', 20". In particular, this allows the use of a display 14 with Boolean charging bars 15, 15' 15", 15''' corresponding to each of the respective zones. In order to arrive at a simple yet precise display, specific preset / predefined limits can be used to determine whether the corresponding Boolean charging bar 15, 15' 15", 15''' should be set to 0 or one, depending on the individual SOC calculated for the corresponding zone 20, 20', 20". In the figure, corresponding zones 20, 20', 20" and 15, 15' 15", 15''' are marked by corresponding letters A, B, C.

**Claims**

1. Method for determining a state-of-charge, SOC, of a phase-change-material-based thermal energy storage device, PCM-TES (1), with a storage module (9) that comprises a phase change material (3) for storing thermal energy, comprising the method steps of:

   a) measuring at least one surface temperature (Ts) at the storage module (9) of the PCM-TES (1) as a first temperature;
   b) determining an operating condition of the PCM-TES (1);
   if the operating condition is determined to be an active condition where a heat transfer fluid is flowing through an outlet (11) of the PCM-TES (1): **characterized by**
   c) measuring a liquid temperature (Tl) at the outlet (11) of the PCM-TES (1) as a second temperature;
   d) calculating at least one first SOC-value $SOC_{surface}$ with a first chosen function of the first temperature;
   e) calculating a second SOC-value $SOC_{outlet}$ with a second chosen function of the second temperature;
   f) determining the SOC of the PCM-TES $SOC_{total}$ with a third chosen function of the at least one calculated first SOC-value $SOC_{surface}$ and of the calculated second SOC-value $SOC_{outlet}$.

2. Method according to the precedent claim,
   **characterized in that**
   the operating condition to be determined is chosen from a given set of discrete operating conditions preferably comprising the active condition and an idle condition where the heat transfer fluid is not flowing through the outlet (11) of the PCM-TES (1), in particular only the active and the idle condition.

3. Method according to any of the precedent claims,
   **characterized in that**
   if the operating condition is determined to be the idle condition:
   f2) determining the SOC of the PCM-TES $SOC_{total}$ with a fourth chosen function of the first temperature, where the fourth chosen function is different from the third chosen function.

4. Method according to the precedent claim,
   **characterized in that**
   said fourth chosen function is the first chosen function and/or a chosen function converting, preferably continuously converting, the third chosen function into the first chosen function over time after the idle condition has been determined.

5. Method according to any of the precedent claims,
   **characterized in that**
   the at least one surface temperature is a temperature of a storage module wall (4) and/or the liquid temperature is a temperature of the heat transfer fluid flowing through the outlet (11).

6. Method according to any of the precedent claims,
   **characterized in that**

   - in the measuring step a) several surface temperatures are measured as respective several first temperatures, where the respective surface temperatures correspond to different zones (20, 20', 20") of the PCM-TES (1);
   - in the calculating step d) several first SOC-values $SOC_{surface}$ are calculated with the first chosen function of the measured several first temperatures; and
   - in the determining step f), the SOC of the PCM-TES (1) $SOC_{total}$ is determined by a sum of respective chosen given functions, which are functions of the respective calculated first SOC-value $SOC_{surface}$ and of the calculated second SOC-value $SOC_{outlet\,(11)}$.

7. Method according to any of the precedent claims,
   **characterized in that**
   the determined combined SOC $SOC_{combined}$ of the third chosen function of the determining f) is proportional to a weighted average of the first SOC-value $SOC_{surface}$ of the calculating step d) and the second SOC-value $SOC_{outlet}$ of

the calculating step e), in particular $SOC_{combined} = z_1(0)*SOC_{surface} + z_2(0)*SOC_{outlet}$, with $z_1(0)$ and $z_2(0)$ being constant values.

8. Method according to any of the precedent claims,
**characterized in that**
the fourth chosen function is given by $SOC_{total} = y_1(t_{idle})*SOC_{surface} + y_2(t_{idle})*SOC_{combined}$, where $y_1(t_{idle})$ and $y_2(t_{idle})$ vary with idling time $t_{idle}$ of the PCM-TES (1) and $y_1(t_{idle}) + y_2(t_{idle}) = $ constant, in particular $y_1(t_{idle}) + y_2(t_{idle}) = 1$.

9. Method according to the precedent claim,
**characterized in that**
$y_1(t_{idle}=0) = 0$ and $y_2(t_{idle}=0) = 1$, and preferably $y_1(t_{idle}\rightarrow\infty) = 1$ and $y_2(t_{idle}\rightarrow\infty) = 0$ or in a mathematically equivalent manner such as $y_1(t_{active}=0) = 1$ and $y_2(t_{active}=0) = 0$, and preferably with $y_1(t_{active}\rightarrow\infty) = 0$ and $y_2(t_{active}\rightarrow\infty) = 1$, where active time $t_{active}$ of the PCM-TES (1) replaces idling time $t_{idle}$ and is a time measured from the time where the active condition is determined.

10. Method according to any of the precedent claims,
**characterized in that**

the first given function is an empiric function mapping the first temperature to an enthalpy-based SOC-value $SOC_{enthalpy}$, which is preferably determined based on the equation

$$SOC_{enthalpy} = {}_0\!\int^t \dot{m}_{HTF} * c_{p,\,HTF} * \left(T_{HTF,\,in} - T_{HTF}\right) / Q_{total},$$

wherein $\dot{m}_{HTF}$ is a flow rate of the heat transfer fluid, $c_{p,\,HTF}$ is a specific heat capacity of the heat transfer fluid, $T_{HTF,\,in}$ is a heat transfer fluid inlet temperature at an inlet of the PCM-TES (1), $T_{HTF}$ is a heat transfer fluid outlet temperature at the outlet (11) of the PCM-TES (1), and $Q_{total}$ is a total heat storage capacity at a selected maximum temperature of operation of the PCM-TES (1).

11. Method according to any of the precedent claims,
**characterized in that**
the second given function is a step function mapping the second temperature to the SOC-value $SOC_{outlet}$.

12. Phase-change-material-based thermal energy storage device, PCM-TES (1), with

- a storage module (9) that comprises a phase change material (3) for storing thermal energy;
- at least one first temperature sensor unit (6a, 6a', 6a", 6a*) for measuring a respective surface temperature (Ts) at the storage module (9) as a first temperature; **characterized by**
- a second temperature sensor unit (6b, 6b') for measuring a liquid temperature (Tl) at an outlet (11) of the PCM-TES (1) as a second temperature; and
- a determination unit (13) for determining an operating condition of the PCM-TES (1), and,

the determination unit (13) being configured to, if the operating condition is determined to be an active condition where a heat transfer fluid is flowing through the outlet (11) of the PCM-TES (1): determining a state-of-charge, SOC, of the PCM-TES $SOC_{combined}$ with a third chosen function of at least one calculated first SOC-value $SOC_{surface}$, which is calculated with a first given function of the first temperature, and of a calculated second SOC-value $SOC_{outlet}$, which is calculated with a second given function of the second temperature.

13. Phase-change-material-based thermal energy storage device according to claim 12, where a fourth given function is used to calculate the overall $SOC_{total}$ from $SOC_{combined}$ and $SOC_{surface}$ depending on the operating condition.

**Patentansprüche**

1. Verfahren zum Bestimmen eines Ladezustands, SOC, einer phasenwechselmaterialbasierten thermischen Energiespeichereinrichtung, PCM-TES (1), mit einem Speichermodul (9), das ein Phasenwechselmaterial (3) zur Speicherung thermischer Energie umfasst, umfassend die Verfahrensschritte:

a) Messen mindestens einer Oberflächentemperatur (Ts) am Speichermodul (9) der PCM-TES (1) als eine erste Temperatur;
b) Bestimmen eines Betriebszustands der PCM-TES (1);
wenn der Betriebszustand als ein aktiver Zustand bestimmt wird, in dem ein Wärmetransferfluid durch einen Auslass (11) der PCM-TES (1) strömt: **gekennzeichnet durch**
c) Messen einer Flüssigkeitstemperatur (Tl) am Auslass (11) der PCM-TES (1) als eine zweite Temperatur;
d) Berechnen mindestens eines ersten SOC-Wertes $SOC_{surface}$ mit einer ersten gewählten Funktion der ersten Temperatur;
e) Berechnen eines zweiten SOC-Wertes $SOC_{outlet}$ mit einer zweiten gewählten Funktion der zweiten Temperatur;
f) Bestimmen des SOC der PCM-TES $SOC_{total}$ mit einer dritten gewählten Funktion des mindestens einen berechneten ersten SOC-Wertes $SOC_{surface}$ und des berechneten zweiten SOC-Wertes $SOC_{outlet}$.

2. Verfahren nach dem vorangehenden Anspruch,
**dadurch gekennzeichnet, dass**
der zu bestimmende Betriebszustand aus einem gegebenen Satz diskreter Betriebszustände ausgewählt wird, die vorzugsweise den aktiven Zustand und einen Leerlaufzustand umfassen, in dem das Wärmetransferfluid nicht durch den Auslass (11) der PCM-TES (1) strömt, insbesondere nur den aktiven und den Leerlaufzustand.

3. Verfahren nach einem der vorangehenden Ansprüche,
**dadurch gekennzeichnet, dass**
wenn als Betriebszustand der Leerlaufzustand bestimmt wird:
f2) Bestimmen des SOC der PCM-TES $SOC_{total}$ mit einer vierten gewählten Funktion der ersten Temperatur, wobei die vierte gewählte Funktion von der dritten gewählten Funktion verschieden ist.

4. Verfahren nach dem vorangehenden Anspruch,
**dadurch gekennzeichnet, dass**
die vierte gewählte Funktion die erste gewählte Funktion und/oder eine gewählte Funktion ist, die die dritte gewählte Funktion in die erste gewählte Funktion umwandelt, vorzugsweise kontinuierlich umwandelt, und zwar im Laufe der Zeit, nachdem der Leerlaufzustand bestimmt wurde.

5. Verfahren nach einem der vorangehenden Ansprüche,
**dadurch gekennzeichnet, dass**
die mindestens eine Oberflächentemperatur eine Temperatur einer Speichermodulwand (4) ist und/oder die Flüssigkeitstemperatur eine Temperatur der durch den Auslass (11) strömenden Wärmetransferflüssigkeit ist.

6. Verfahren nach einem der vorangehenden Ansprüche,
**dadurch gekennzeichnet, dass**

   - im Messschritt a) mehrere Oberflächentemperaturen als jeweils mehrere erste Temperaturen gemessen werden, wobei die jeweiligen Oberflächentemperaturen verschiedenen Zonen (20, 20', 20") der PCM-TES (1) entsprechen;
   - im Berechnungsschritt d) mehrere erste SOC-Werte $SOC_{surface}$ mit der ersten gewählten Funktion der gemessenen mehreren ersten Temperaturen berechnet werden; und
   - im Bestimmungsschritt f) der SOC der PCM-TES (1) $SOC_{total}$ durch eine Summe von jeweils gewählten gegebenen Funktionen bestimmt wird, die Funktionen des jeweils berechneten ersten SOC-Wertes $SOC_{surface}$ und des berechneten zweiten SOC-Wertes $SOC_{outlet(11)}$ sind.

7. Verfahren nach einem der vorangehenden Ansprüche,
**dadurch gekennzeichnet, dass**
der bestimmte kombinierte SOC $SOC_{combined}$ der dritten gewählten Funktion der Bestimmung f) proportional zu einem gewichteten Mittelwert des ersten SOC-Wertes $SOC_{surface}$ des Berechnungsschritts d) und des zweiten SOC-Wertes $SOC_{outlet}$ des Berechnungsschritts e) ist, insbesondere gilt $SOC_{combined} = z_1(0)*SOC_{surface}+z_2(0)*SOC_{outlet}$, wobei $z_1(0)$ und $z_2(0)$ konstante Werte sind.

8. Verfahren nach einem der vorangehenden Ansprüche,
**dadurch gekennzeichnet, dass**
die vierte gewählte Funktion gegeben ist durch $SOC_{total} = y_1(t_{idle})*SOC_{surface}+y_2(t_{idle})*SOC_{combined}$, wobei $y_1(t_{idle})$

und $y_2(t_{idle})$ mit der Leerlaufzeit $t_{idle}$ der PCM-TES (1) variieren und $y_1(t_{idle}) + y_2(t_{idle})$ = konstant, insbesondere $y_1(t_{idle}) + y_2(t_{idle})$ = 1, gilt.

9. Verfahren nach dem vorangehenden Anspruch,
   **dadurch gekennzeichnet, dass**
   $y_1(t_{idle}=0) = 0$ und $y_2(t_{idle}=0) = 1$, und vorzugsweise $y_1(t_{idle}\rightarrow\infty) = 1$ und $y_2(t_{idle}\rightarrow\infty) = 0$ oder mathematisch äquivalent wie zum Beispiel $y_1(t_{active}=0) = 1$ und $y_2(t_{active}=0) = 0$, und vorzugsweise mit $y_1(t_{active}\rightarrow\infty) = 0$ und $y_2(t_{active}\rightarrow\infty) = 1$, wobei die aktive Zeit $t_{active}$ der PCM-TES (1) die Leerlaufzeit $t_{idle}$ ersetzt und eine Zeit ist, die ab dem Zeitpunkt gemessen wird, zu dem der aktive Zustand bestimmt wird.

10. Verfahren nach einem der vorangehenden Ansprüche,
    **dadurch gekennzeichnet, dass**

    die erste gegebene Funktion eine empirische Funktion ist, die die erste Temperatur auf einen enthalpie-basierten SOC-Wert $SOC_{ent-halpy}$ abbildet, der vorzugsweise auf der Grundlage der folgenden Gleichung bestimmt wird

    $$SOC_{enthalpy} = {_0\int^t} \dot{m}_{HTF} * c_{p, HTF} * (T_{HTF, in} - T_{HTF}) / Q_{total},$$

    wobei $\dot{m}_{HTF}$ eine Strömungsrate des Wärmetransferfluids ist, $c_{p, HTF}$ eine spezifische Wärmekapazität des Wärmetransferfluids ist, $T_{HTF, in}$ eine Wärmetransferfluid-Einlasstemperatur an einem Einlass der PCM-TES (1) ist, $T_{HTF}$ eine Wärmetransferfluid-Auslasstemperatur am Auslass (11) der PCM-TES (1) ist, und $Q_{total}$ eine Gesamtwärmespeicherkapazität bei einer ausgewählten maximalen Betriebstemperatur der PCM-TES (1) ist.

11. Verfahren nach einem der vorangehenden Ansprüche
    **dadurch gekennzeichnet, dass**
    die zweite gegebene Funktion eine Stufenfunktion ist, die die zweite Temperatur auf den SOC-Wert $SOC_{outlet}$ abbildet.

12. Phasenwechselmaterialbasierte thermische Energiespeichereinrichtung, PCM-TES (1), mit

    - einem Speichermodul (9), das ein Phasenwechselmaterial (3) zur Speicherung thermischer Energie umfasst;
    - mindestens einer ersten Temperatursensoreinheit (6a, 6a', 6a", 6a*) zum Messen einer jeweiligen Oberflächentemperatur (Ts) am Speichermodul (9) als eine erste Temperatur; **gekennzeichnet durch**
    - eine zweite Temperatursensoreinheit (6b, 6b') zum Messen einer Flüssigkeitstemperatur (TI) an einem Auslass (11) der PCM-TES (1) als eine zweite Temperatur; und
    - eine Bestimmungseinheit (13) zum Bestimmen eines Betriebszustands der PCM-TES (1), und,
    wobei die Bestimmungseinheit (13) eingerichtet ist, wenn der Betriebszustand als ein aktiver Zustand bestimmt wird, in dem ein Wärmetransferfluid durch den Auslass (11) der PCM-TES (1) strömt, zum: Bestimmen eines Ladezustands, SOC, der PCM-TES $SOC_{combined}$ mit einer dritten gewählten Funktion von mindestens einem berechneten ersten SOC-Wert $SOC_{surface}$, der mit einer ersten gegebenen Funktion der ersten Temperatur berechnet wird, und einem berechneten zweiten SOC-Wert $SOC_{outlet}$, der mit einer zweiten gegebenen Funktion der zweiten Temperatur berechnet wird.

13. Phasenwechselmaterialbasierte thermische Energiespeichereinrichtung nach Anspruch 12, wobei eine vierte gegebene Funktion zum Berechnen des gesamten $SOC_{total}$ aus $SOC_{combined}$ und $SOC_{surface}$ in Abhängigkeit vom Betriebszustand verwendet wird.

**Revendications**

1. Procédé de détermination d'un état de charge, SOC, d'un dispositif de stockage d'énergie thermique à base de matériau à changement de phase, PCM-TES (1), avec un module de stockage (9) qui comprend un matériau à changement de phase (3) pour stocker de l'énergie thermique, comprenant les étapes de procédé consistant à :

   a) mesurer au moins une température de surface (Ts) au niveau du module de stockage (9) du PCM-TES (1) en tant que première température ;
   b) déterminer une condition de fonctionnement du PCM-TES (1) ;

si la condition de fonctionnement est déterminée comme étant une condition active où un fluide de transfert de chaleur s'écoule à travers une sortie (11) du PCM-TES (1) : **caractérisé par** les étapes consistant à

c) mesurer une température de liquide (TI) au niveau de la sortie (11) du PCM-TES (1) en tant que seconde température ;

d) calculer au moins une première valeur de SOC, $SOC_{surface}$, avec une première fonction choisie de la première température ;

e) calculer une seconde valeur de SOC, $SOC_{outlet}$, avec une deuxième fonction choisie de la seconde température ;

f) déterminer le SOC du PCM-TES, $SOC_{total}$, avec une troisième fonction choisie de la au moins une première valeur SOC, $SOC_{surface}$, calculée et de la seconde valeur de SOC, $SaC_{outlet}$, calculée.

2. Procédé selon la revendication précédente,
   **caractérisé en ce que**
   la condition de fonctionnement à déterminer est choisie parmi un ensemble donné de conditions de fonctionnement distinctes comprenant de préférence la condition active et une condition de repos où le fluide de transfert de chaleur ne s'écoule pas à travers la sortie (11) du PCM-TES (1), en particulier uniquement la condition active et la condition de repos.

3. Procédé selon l'une quelconque des revendications précédentes,
   **caractérisé en ce que**
   si la condition de fonctionnement est déterminée comme étant la condition de repos :
   f2) déterminer le SOC du PCM-TES, $SOC_{total}$, avec une quatrième fonction choisie de la première température, où la quatrième fonction choisie est différente de la troisième fonction choisie.

4. Procédé selon la revendication précédente,
   **caractérisé en ce que**
   ladite quatrième fonction choisie est la première fonction choisie et/ou une fonction choisie convertissant, de préférence convertissant en continu, la troisième fonction choisie en la première fonction choisie au fil du temps après que la condition de repos a été déterminée.

5. Procédé selon l'une quelconque des revendications précédentes,
   **caractérisé en ce que**
   la au moins une température de surface est une température d'une paroi de module de stockage (4) et/ou la température de liquide est une température du fluide de transfert de chaleur s'écoulant à travers la sortie (11).

6. Procédé selon l'une quelconque des revendications précédentes,
   **caractérisé en ce que**

   - à l'étape de mesure a), plusieurs températures de surface sont mesurées en tant que plusieurs premières températures respectives, les températures de surface respectives correspondant à différentes zones (20, 20', 20") du PCM-TES (1) ;
   - à l'étape de calcul d), plusieurs premières valeurs de SOC, $SOC_{surface}$, sont calculées avec la première fonction choisie des plusieurs premières températures mesurées ; et
   - à l'étape de détermination f), le SOC du PCM-TES (1), $SOC_{total}$, est déterminé par une somme de fonctions données choisies respectives, qui sont des fonctions de la première valeur de SOC, $SOC_{surface}$, calculée respective et de la seconde valeur de SOC, $SOC_{outlet(11)}$ calculée.

7. Procédé selon l'une quelconque des revendications précédentes,
   **caractérisé en ce que**
   le SOC combiné déterminé, $SOC_{combined}$, de la troisième fonction choisie de la détermination f) est proportionnel à une moyenne pondérée de la première valeur de SOC, $SOC_{surface}$, de l'étape de calcul d) et la seconde valeur de SOC, $SOC_{outlet}$, de l'étape de calcul e), en particulier $SOC_{combined} = z_1(0)*SOC_{surface} + z_2(0)*SOC_{outlet}$, avec $z_1(0)$ et $z_2(0)$ étant des valeurs constantes.

8. Procédé selon l'une quelconque des revendications précédentes,
   **caractérisé en ce que**
   la quatrième fonction choisie est donnée par $SOC_{to-tal} = Y_1(t_{idle})*SOC_{surface} + y_2(t_{idle})*SOC_{combined}$, où $y_1(t_{idle})$ et $y_2(t_{idle})$ varient avec le temps de repos $t_{idle}$ du PCM-TES (1) et $y_1(t_{idle}) + y_2(t_{idle}) = $ constant, en particulier $y_1(t_{idle}) + y_2$

($t_{idle}$) = 1.

9. Procédé selon la revendication précédente,
**caractérisé en ce que**
$y_1(t_{idle}=0) = 0$ et $y_2(t_{idle}=0) = 1$, et de préférence $y_1(t_{idle}\rightarrow\infty) = 1$ et $y_2(t_{idle}\rightarrow\infty) = 0$ ou d'une manière mathématiquement équivalente telle que $y_1(t_{active}=0) = 1$ et $y_2(t_{active}=0) = 0$, et de préférence avec $y_1(t_{ac-tive}\rightarrow\infty) = 0$ et $y_2(t_{active}\rightarrow\infty) = 1$, où le temps actif $t_{active}$ du PCM-TES (1) remplace le temps de repos $t_{idle}$ et est un temps mesuré à partir du moment où la condition active est déterminée.

10. Procédé selon l'une quelconque des revendications précédentes,
**caractérisé en ce que**

la première fonction donnée est une fonction empirique mettant en correspondance la première température et une valeur de SOC basée sur l'enthalpie, $SOC_{enthalpy}$, qui est de préférence déterminée sur la base de l'équation

$$SOC_{enthalpy} = {}_0\!\int^t \dot{m}_{HTF} * c_{p,\,HTF} * (T_{HTF,\,in} - T_{HTF}) / Q_{total},$$

dans laquelle $\dot{m}_{HTF}$ est un débit d'écoulement du fluide de transfert de chaleur, $C_{p,\,HTF}$ est une capacité de chaleur spécifique du fluide de transfert de chaleur, $T_{HTF,\,in}$ est une température d'entrée de fluide de transfert de chaleur au niveau d'une entrée du PCM-TES (1), $T_{HTF}$ est une température de sortie de fluide de transfert de chaleur au niveau de la sortie (11) du PCM-TES (1), et $Q_{total}$ est une capacité de stockage de chaleur totale à une température maximum sélectionnée de fonctionnement du PCM-TES (1).

11. Procédé selon l'une quelconque des revendications précédentes,
**caractérisé en ce que**
la seconde fonction donnée est une fonction d'étape mettant en correspondance la seconde température et la valeur SOC, $SOC_{outlet}$.

12. Dispositif de stockage d'énergie thermique à base de matériau à changement de phase, PCM-TES (1), avec

- un module de stockage (9) qui comprend un matériau à changement de phase (3) pour stocker de l'énergie thermique ;
- au moins une première unité de capteur de température (6a, 6a', 6a", 6a*) pour mesurer une température de surface respective (Ts) au niveau du module de stockage (9) en tant que première température ;
**caractérisé par**
- une seconde unité de capteur de température (6b, 6b') pour mesurer une température de liquide (TI) au niveau d'une sortie (11) du PCM-TES (1) en tant que seconde température ; et
- une unité de détermination (13) pour déterminer une condition de fonctionnement du PCM-TES (1), et,
l'unité de détermination (13) étant configurée pour, si la condition de fonctionnement est déterminée comme étant une condition active où un fluide de transfert de chaleur s'écoule à travers la sortie (11) du PCM-TES (1) : déterminer un état de charge, SOC, du PCM-TES, $SOC_{combined}$, à une troisième fonction choisie d'au moins une première valeur de SOC calculée, $SOC_{surface}$, qui est calculée avec une première fonction donnée de la première température, et d'une seconde de valeur SOC calculée, $SOC_{outlet}$, qui est calculée avec une deuxième fonction donnée de la seconde température.

13. Dispositif de stockage d'énergie thermique à base de matériau à changement de phase selon la revendication 12, dans lequel une quatrième fonction donnée est utilisée pour calculer le SOC global, $SOC_{total}$, à partir de $SOC_{combined}$ et de $SOC_{surface}$ en fonction de la condition de fonctionnement.

Fig. 1

Fig. 2

Fig. 3

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2482021 A2
- AU 2018202778 B2
- US 2014102662 A1
- EP 3336473 A1
- WO 2018122392 A1
- US 2014158340 A1